# EUROPÄISCHE PATENTSCHRIFT

(11) **EP 3 719 506 B1**
(45) Veröffentlichungstag und Bekanntmachung des Hinweises auf die Patenterteilung: **11.08.2021**
(21) Anmeldenummer: 20162565.4
(22) Anmeldetag: 12.03.2020
(51) Int. Cl.: G01R 1/20

(54) **STROMMESSBAUGRUPPE**
CURRENT MEASURING ASSEMBLY
MODULE DE MESURE DE COURANT

(30) Priorität: 02.04.2019 DE 102019108541
(43) Veröffentlichungstag der Anmeldung: 07.10.2020
(73) Patentinhaber: Eberspächer Controls Landau GmbH & Co. KG, 76829 Landau (DE)
(72) Erfinder: Wandres, Steffen, 76870 Kandel (DE); Weimann, Mark-Arno, 67686 Mackenbach (DE)
(74) Vertreter: Ruttensperger Lachnit Trossin Gomoll

(56) Entgegenhaltungen:
- EP-A1- 1 621 892
- WO-A1-2007/062943
- WO-A1-2018/055958
- DE-A1-102004 040 575
- DE-A1-102006 019 895
- JP-A- 2009 063 527
- JP-A- 2015 215 167

## Beschreibung

Die vorliegende Erfindung betrifft eine Strommessbaugruppe, welche insbesondere eingesetzt werden kann, um in Fahrzeugen, wie zum Beispiel elektromotorisch betriebenen Fahrzeugen, den Batteriestrom zu messen.

Für ein geeignetes Batteriemanagement bei Lithium-Ionen-Batterien, die beispielsweise in elektromotorisch betriebenen Fahrzeugen als Energiequelle genutzt werden, werden Batteriemanagementsysteme eingesetzt, die unter anderem den Batteriestrom erfassen und auswerten. Da die Ströme in derartigen elektrischen Antriebssystemen für Fahrzeuge sehr hoch sein können, müssen derartige Batteriemanagementsysteme für die Erfassung derartig hoher Ströme ausgelegt sein.

Eine Strommessbaugruppe gemäß dem Oberbegriff des Anspruchs 1 ist aus der JP 2015 215167 A bekannt. Bei dieser bekannten Strommessbaugruppe sind zwischen zwei Stromschienen zwei zu einer Leiterplatte führende Messleiterbahnen und zwischen den beiden Messleiterbahnen ein Shunt-Widerstand angeordnet. Die beiden Stromschienen und die dazwischen angeordneten Messleiterbahnen und der Shunt-Widerstand sind durch eine diese durchsetzende Schraube zu einer Baugruppe zusammengefasst, so dass die Stromschienen über die zwischen diesen und dem Shunt-Widerstand liegenden Messleiterbahnen mit den Messleiterbahnen einerseits und dem Shunt-Widerstand andererseits verbunden sind.

Aus der JP 2009 063527 A ist eine Strommessbaugruppe bekannt, bei welcher beidseits eines Shunt-Widerstandes zu einer Leiterplatte führende Messleiterbahnen angeordnet sind. An jede der Messleiterbahnen ist ein stromführendes Kabel angebunden.

Die EP 1 621 892 A1 offenbart eine Strommessbaugruppe, bei welcher zwischen den Enden zweier elektrischer Anschlusselemente ein Nennwiderstand angeordnet ist. Von jedem Ende der beiden elektrischen Anschlusselemente führt ein als Bonddraht ausgebildeter elektrischer Leiter zu einer Messelektronik.

Die DE 10 2004 040 575 A1 offenbart eine Strommessbaugruppe, bei welcher ein Ende eines elektrisch leitenden Kabels vermittels eines Crimp-Anschlusses an einen Leiter angebunden ist. Der Leiter ist mit einem Widerstandselement aufgebaut und über Leiterabschnitte in Verbindung mit einer Leiterplatte.

Aus der DE 10 2006 019 895 A1 ist eine Strommessbaugruppe bekannt, bei welcher zwischen zwei Stromanschlussteilen ein Widerstandselement angeordnet ist. In jedes der Stromanschlussteile ist ein zu einer Leiterplatte führendes Verbindungselement eingesetzt.

Die WO 2007/062943 offenbart eine Strommessvorrichtung, bei welcher zwischen zwei der elektrischen Kontaktierung dienenden Anschlüssen ein Messwiderstand angeordnet ist. Zum Abgreifen der elektrischen Spannung beidseits des Messwiderstands sind an einer Leiterplatte Kontaktelemente hervorstehend vorgesehen.

Aus der WO 2018/055958 A1 ist eine Strommessbaugruppe bekannt, bei welcher zwischen zwei plattenartigen Leiterelementen ein Messwiderstand angeordnet ist. Von jedem der plattenartigen Leiterelemente verläuft ein Erfassungsanschluss zu einer auf einer Leiterplatte vorgesehenen Leiterbahn.

Es ist die Aufgabe der vorliegenden Erfindung, eine Strommessbaugruppe, insbesondere zum Messen des Batteriestroms in einem Fahrzeug, bereitzustellen, welche bei einfach und kostengünstig zu realisierendem Aufbau eine zuverlässige Erfassung hoher Ströme ermöglicht.

Erfindungsgemäß wird diese Aufgabe gelöst durch eine Strommessbaugruppe, insbesondere zum Messen des Batteriestroms in einem Fahrzeug, umfassend:
- eine Leiterplatte,
- eine zu der Leiterplatte führende und an der Leiterplatte festgelegte erste Stromschiene, wobei die erste Stromschiene wenigstens eine erste Shunt-Kontaktfläche bereitstellt,
- eine zu der Leiterplatte führende und an der Leiterplatte festgelegte zweite Stromschiene, wobei die zweite Stromschiene wenigstens eine zweite Shunt-Kontaktfläche bereitstellt,
- in Zuordnung zu der ersten Stromschiene eine erste Messleiterbahn an der Leiterplatte,
- in Zuordnung zu der zweiten Stromschiene eine zweite Messleiterbahn an der Leiterplatte,
- einen Shunt-Widerstand mit einem durch Verlötung mit der ersten Stromschiene und der ersten Messleiterbahn verbundenen ersten Kontaktbereich und einem durch Verlötung mit der zweiten Stromschiene und der zweiten Messleiterbahn verbundenen zweiten Kontaktbereich.

Durch die direkte Anbindung eines derartigen bei der Strommessung eingesetzten Shunt-Widerstands an die beiden zu der Leiterplatte führenden Stromschienen wird nicht nur eine elektrische Kontaktierung zu dem zu überwachenden Stromkreis hergestellt, sondern auch die Möglichkeit geschaffen, die in einem derartigen Shunt-Widerstand im Allgemeinen in Form von Wärme anfallende Verlustleistung über die Stromschienen zuverlässig abzuführen. Dies ermöglicht den Einsatz beispielsweise sogenannter SMD-(Surface-Mounted-Device)-Shunt-Widerstände mit einer vergleichsweise kleinen Verlustleistung, welche dann in Form von Wärme effizient abgeführt werden kann, so dass eine Überlastung vermieden wird und der Einsatz von für höhere Verlustleistungen ausgelegten Widerständen nicht erforderlich ist. Gleichzeitig ermöglicht der Aufbau der Strommessbaugruppe die Erfassung des über die Stromschienen geleiteten elektrischen Stroms vermittels einer Vierleitermessung. Zur Herstellung einer elektrischen Verbindung zwischen den Stromschienen und dem Shunt-Widerstand weist die Leiterplatte in Zuordnung zu der ersten Stromschiene eine erste Mess-Durchgriffsöffnung auf, wobei die erste Stromschiene einen in die erste Mess-Durchgriffsöffnung eingesetzten Durchgriff/Kontakt-Bereich aufweist, und wobei der erste Durchgriff/Kontakt-Bereich der ersten Stromschiene die im Bereich einer ersten Seite der Leiterplatte positionierte erste Shunt-Kontaktfläche bereitstellt und die erste Stromschiene sich an einer von der ersten Seite abgewandten zweiten Seite der Leiterplatte erstreckt, und weist die Leiterplatte in Zuordnung zu der zweiten Stromschiene eine zweite Mess-Durchgriffsöffnung auf, wobei die zweite Stromschiene einen in die zweite Mess-Durchgriffsöffnung eingesetzten zweiten Durchgriff/Kontakt-Bereich aufweist, und wobei der zweite Durchgriff/Kontakt-Bereich der zweiten Stromschiene die im Bereich der ersten Seite der Leiterplatte positionierte zweite Shunt-Kontaktfläche bereitstellt und die zweite Stromschiene sich an der von der ersten Seite abgewandten zweiten Seite der Leiterplatte erstreckt.

Dabei kann ein gegenseitiges Stören mit anderen an der Leiterplatte vorgesehenen Systembereichen dadurch vermieden werden, dass die erste Shunt-Kontaktfläche oder/und die zweite Shunt-Kontaktfläche zu einer Oberfläche der Leiterplatte an der ersten Seite im Wesentlichen bündig liegt.

Bei einer einfach herzustellenden, gleichwohl jedoch stabilen Ausgestaltung kann der erste Durchgriff/Kontakt-Bereich eine napfartige Ausformung an der ersten Stromschiene umfassen, oder/und kann der zweite Durchgriff/Kontakt-Bereich eine napfartige Ausformung an der zweiten Stromschiene umfassen.

Für eine effiziente Abfuhr von Wärme aus dem Bereich der Leiterplatte wird weiter vorgeschlagen, dass die erste Stromschiene an der zweiten Seite der Leiterplatte in Abstand zur Leiterplatte angeordnet ist, oder/und dass die zweite Stromschiene an der zweiten Seite der Leiterplatte in Abstand zur Leiterplatte angeordnet ist.

Eine stabile Halterung der Stromschienen an der Leiterplatte kann in einfacher Weise dadurch hergestellt werden, dass der erste Durchgriff/Kontakt-Bereich mit Presspassung in der ersten Mess-Durchgriffsöffnung aufgenommen ist, oder/und dass der zweite Durchgriff/Kontakt-Bereich mit Presspassung in der zweiten Mess-Durchgriffsöffnung aufgenommen ist.

Zur elektrischen Kontaktierung sowohl einer jeweiligen Stromschiene als auch der zugeordneten Messleiterbahn kann bei wenigstens einem Kontaktbereich von erstem Kontaktbereich und zweitem Kontaktbereich die Verlötung einen die zugeordnete Shunt-Kontaktfläche im Wesentlichen vollständig überdeckenden und eine Verbindung mit der zugeordneten Messleiterbahn herstellenden Verlötungsbereich umfassen. Alternativ kann vorgesehen sein, dass bei wenigstens einem Kontaktbereich von erstem Kontaktbereich und zweitem Kontaktbereich die Verlötung einen die zugeordnete Shunt-Kontaktfläche im Wesentlichen vollständig überdeckenden ersten Verlötungsbereich und einen von dem ersten Verlötungsbereich getrennten, eine Verbindung mit der zugeordneten Messleiterbahn herstellenden zweiten Verlötungsbereich umfasst.

An der Leiterplatte kann ferner in Kontakt mit der ersten Messleiterbahn und der zweiten Messleiterbahn Messelektronik vorgesehen sein.

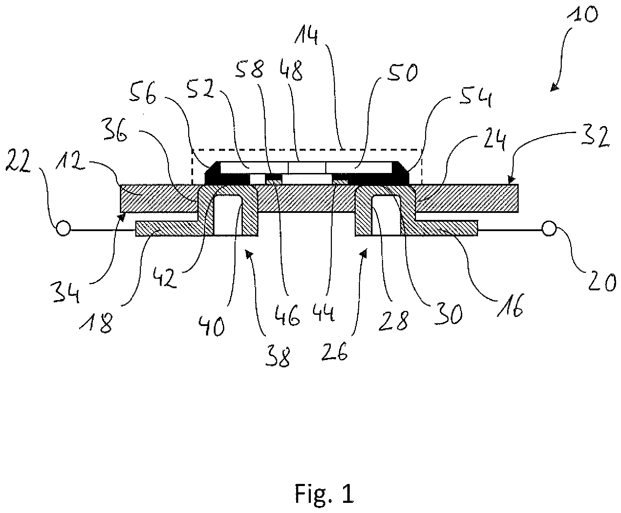

Die vorliegende Erfindung wird nachfolgend mit Bezug auf die beiliegende Fig. 1 detailliert beschrieben, welche in Schnittdarstellung eine Strommessbaugruppe zeigt.

Die in Fig. 1 dargestellte Strommessbaugruppe 10 umfasst eine Leiterplatte 12. An der Leiterplatte 12 ist eine schematisch angedeutete Messelektronik 14 vorgesehen, über welche der über zwei Stromschienen 16, 18 fließende elektrische Strom erfasst bzw. ausgewertet werden kann. Die Messelektronik 14 kann beispielsweise einen Mikroprozessor umfassen.

Bei Einsatz der Strommessbaugruppe 10 zum Messen des Batteriestroms einer Lithium-Ionen-Batterie zum Beispiel in einem elektromotorisch betriebenen Fahrzeug kann beispielsweise die erste Stromschiene 16 an eine in einem Fahrzeug vorgesehene Anschlussklemme 20 anschließen, während die zweite Stromschiene 18 an einen schematisch angedeuteten Pluspol oder Minuspol 22 der Batterie angeschlossen sein kann. Selbstverständlich ist die Integration der Strommessbaugruppe 10 in andere Bereiche der Stromführung zwischen einer Batterie und einem Verbraucher elektrischer Energie, wie z. B. dem Antriebsmotor in einem elektromotorisch betriebenen Fahrzeug, möglich.

In Zuordnung zur ersten Stromschiene 16 weist die Leiterplatte 12 eine erste Mess-Durchgriffsöffnung 24 auf. An der ersten Stromschiene 16 ist ein erster Durchgriff/Kontakt-Bereich 26 vorgesehen, der in die erste Mess-Durchgriffsöffnung 24 eingreifend positioniert ist und in dieser beispielsweise durch Presspassung festgehalten ist. Der erste Durchgriff/Kontakt-Bereich 26 kann beispielsweise durch eine napfartige Ausformung 28 der beispielsweise aus Kupfermaterial aufgebauten ersten Stromschiene bereitgestellt sein. Der erste Durchgriff/Kontakt-Bereich stellt eine im Wesentlichen der Querschnittfläche der ersten Mess-Durchgriffsöffnung 24 entsprechende erste Shunt-Kontaktfläche 30 bereit. Der erste Durchgriff/KontaktBereich 26 ist derart in die diesen aufnehmende erste Mess-Durchgriffsöffnung 24 eingesetzt, das die erste Shunt-Kontaktfläche 30 im Wesentlichen bündig mit einer Oberfläche an einer ersten Seite 32 der Leiterplatte 12 liegt. Die Stromschiene 16 ist mit ihrem an dem ersten Durchgriff/Kontakt-Bereich 26 anschließenden Abschnitt in Abstand von einer von der ersten Seite 32 abgewandten zweiten Seite 34 der Leiterplatte 12 geführt.

Auch in Zuordnung zur zweiten Stromschiene 18 ist in der Leiterplatte 12 eine zweite Mess-Durchgriffsöffnung 36 vorgesehen. In diese greift ein an der zweiten Stromschiene 18 vorgesehener zweiter Durchgriff/Kontakt-Bereich 38 ein und ist darin beispielsweise durch Presspassung gehalten. An dem beispielsweise wiederum als napfartige Ausformung 40 bereitgestellten zweiten Durchgriff/KontaktBereich 38 ist eine zweite Shunt-Kontaktfläche 42 vorgesehen, welche mit der Oberfläche an der ersten Seite 32 der Leiterplatte 12 im Wesentlichen bündig endet. Auch im Falle der zweiten Stromschiene 18 erstreckt sich der den Durchgriff/KontaktBereich 38 tragende, schienenartige Abschnitt der Stromschiene 18 an der zweiten Seite der Leiterplatte 12 mit Abstand zu dieser. Um diesen Zustand zu gewährleisten bzw. beizubehalten, sind die Stromschienen 16, 18 als unter den im Einsatz der Strommessbaugruppe 10 auftretenden Kräften im Wesentlichen starr bzw. steif zu betrachtende Bauteile ausgebildet.

Es ist darauf hinzuweisen, dass bei einer alternativen Ausgestaltung die Durchgriff/Kontakt-Bereiche 26, 38 auch durch das Anbinden beispielsweise im Wesentlichen kreiszylindrischer Durchgriff/Kontakt-Teile an an der zweiten Seite 34 der Leiterplatte 12 anzuordnende Schienenteile der Stromschienen 16, 18 bereitgestellt sein können. Da sowohl die Durchgriff/Kontakt-Teile als auch die Schienenteile aus Metallmaterial, wie zum Beispiel Kupfer, aufgebaut sind, bietet sich eine Verbindung durch Verschweißung in diesem Falle an.

An der ersten Seite 32 der Leiterplatte 12 sind zwischen den beiden Mess-Durchgriffsöffnungen 24, 36 beispielsweise zur Zeichenebene der Fig. 1 orthogonal verlaufend erste und zweite Messleiterbahnen 44, 46 vorgesehen. Diese führen aus dem Bereich der Mess-Durchgriffsöffnungen 24, 36 in den Bereich der Messelektronik 14. Auch die Leiterbahnen 44, 46 können beispielsweise mit Kupfermaterial aufgebaut sein.

An der Leiterplatte 12 ist ein Shunt-Widerstand 48, vorzugsweise ein SMD-(Surface-Mounted-Device)-Shunt-Widerstand, vorgesehen. Der Shunt-Widerstand 48 ist so positioniert, dass ein erster Kontaktbereich 50 desselben im Wesentlichen die erste Shunt-Kontaktfläche 30 am ersten Durchgriff/Kontakt-Bereich 26 nahezu vollständig überdeckt. Gleichermaßen ist ein zweiter Kontaktbereich 52 des Shunt-Widerstands 48 so positioniert, dass er die zweite Shunt-Kontaktfläche 42 am zweiten Durchgriff/Kontakt-Bereich 38 der zweiten Stromschiene 18 im Wesentlichen vollständig überdeckt. Damit überdecken die beiden Kontaktbereiche 50, 52 auch die zwischen den beiden Mess-Durchgriffsöffnungen 24, 36 verlaufenden Messleiterbahnen 44, 46.

Der erste Kontaktbereich 50 des Shunt-Widerstands 48 ist durch Verlötung an die Leiterplatte 32 bzw. die erste Stromschiene 16 und die erste Messleiterbahn 44 elektrisch und mechanisch angebunden. Hierzu ist ein die erste Shunt-Kontaktfläche 30 im Wesentlichen vollständig überdeckender Verlötungsbereich 54 vorgesehen. Dieser Verlötungsbereich 54 erstreckt sich in Richtung auf die zweite Mess-Durchgriffsöffnung 36 zu über die erste Shunt-Kontaktfläche 30 hinaus derart, dass der Verlötungsbereich 54 auch eine Verlötung zwischen der ersten Messleiterbahn 44 und dem ersten Kontaktbereich 50 herstellt. Es ist in Zuordnung zum ersten Kontaktbereich 50 des Shunt-Widerstands 48 somit ein unterbrechungsfrei über die erste Shunt-Kontaktfläche 30 und über die erste Messleiterbahn 44 hinweg sich erstreckender Bereich der elektrischen und mechanischen Anbindung des Shunt-Widerstands 48 bereitgestellt.

In Zuordnung zum zweiten Kontaktbereich 52 ist eine alternative Ausgestaltung der Verlötung des Shunt-Widerstands 48 mit der Leiterplatte 32 bzw. der daran vorgesehenen zweiten Stromschiene 18 und der zweiten Messleiterbahn 46 vorgesehen. Eine elektrische und mechanische Anbindung des zweiten Kontaktbereichs 52 erfolgt durch einen die zweite Shunt-Kontaktfläche 42 im Wesentlichen vollständig überdeckenden ersten Verlötungsbereich 56. Die elektrische bzw. mechanische Anbindung an die zweite Messleiterbahn 46 erfolgt durch einen vom ersten Verlötungsbereich 56 getrennt ausgebildeten zweiten Verlötungsbereich 58. Es ist darauf hinzuweisen, dass vorzugsweise in Zuordnung zu beiden Stromschienen 16, 18 bzw. den diesen jeweils auch zugeordneten Messleiterbahnen 44, 46 die gleiche Art der Verlötung, also entweder mit einem einzigen Verlötungsbereich 54 oder zwei getrennten Verlötungsbereichen 56, 58 vorgesehen werden kann, um eine symmetrische bzw. gleich belastbare Anbindung zu erreichen. Grundsätzlich können aber in den beiden Kontaktbereichen 50, 52 auch verschiedene Arten der Verlötung realisiert sein.

Durch den vorangehend beschriebenen Aufbau einer Strommessbaugruppe 10 wird es möglich, zur Erfassung des über die beiden Stromschienen 16, 18 geleiteten elektrischen Stroms eine Vier-Leiter-Messung durchzuführen, bei welcher die Messelektronik an den Shunt-Widerstand 48 über die beiden Messleiterbahnen 44, 46 angekoppelt ist. Die großflächige elektrische Kontaktierung der Kontaktbereiche 50, 52 des Shunt-Widerstands 48 mit den Durchgriff/Kontakt-Bereichen der Stromschienen 16, 18 sorgt nicht nur für eine sehr gute elektrische und mechanische Anbindung des Shunt-Widerstands 48, sondern sorgt primär auch für eine effiziente thermische Ankopplung der Kontaktbereiche 50, 52 an die beiden Stromschienen 16, 18. Die Stromschienen 16, 18 haben somit nicht nur die Funktion, den Strom, also beispielsweise den Batteriestrom, zu führen, sondern dienen gleichzeitig auch dazu, im Bereich des Shunt-Widerstands generierte Wärme aus dem Bereich des Shunt-Widerstands 48 und somit dem Bereich der Leiterplatte 12 abzuführen. Dazu trägt auch bei, dass die beiden Stromschienen 16, 18 an der zweiten Seite 34, im Allgemeinen also der Rückseite der Leiterplatte 12, in Abstand von der Leiterplatte 12 verlaufen, so dass ein thermischer Kontakt, über welchen Wärme wieder von den Stromschienen 16, 18 auf die Leiterplatten 12 übertragen werden könnte, vermieden ist. Die Strommessbaugruppe 10 kann in einfacher Art und Weise hergestellt werden, insbesondere auch dadurch, dass die Stromschienen 16, 18 in baulich einfacher, gleichwohl stabiler Weise an die Leiterplatte 12 angebunden werden. Da die im Bereich des Shunt-Widerstands 48 aufgrund der entstehenden Verlustleistung anfallende Wärme effizient abgeführt werden kann, ist eine übermäßige thermische Belastung desselben ausgeschlossen, so dass auf den Einsatz von Leistungs-Shunt-Widerständen verzichtet werden kann und somit ein kostengünstiger und in einfacher Art und Weise durch Verlötung anzubindender SMD-Shunt-Widerstand eingesetzt werden kann.

Es ist abschließend darauf hinzuweisen, dass selbstverständlich an der Leiterplatte 12 auch weitere elektronische Baugruppen vorgesehen sein können. Auch können mehrere derartige Shunt-Widerstände 48 beispielsweise parallel zueinander die beiden Stromschienen 16, 18 miteinander verbindend vorgesehen werden.

## Patentansprüche

1. Strommessbaugruppe, insbesondere zum Messen des Batteriestroms in einem Fahrzeug, umfassend:
- eine Leiterplatte (12),
- eine zu der Leiterplatte (12) führende und an der Leiterplatte (12) festgelegte erste Stromschiene (16), wobei die erste Stromschiene (16) wenigstens eine erste Shunt-Kontaktfläche (30) bereitstellt,
- eine zu der Leiterplatte (12) führende und an der Leiterplatte (12) festgelegte zweite Stromschiene (18), wobei die zweite Stromschiene (18) wenigstens eine zweite Shunt-Kontaktfläche (42) bereitstellt,
- in Zuordnung zu der ersten Stromschiene (16) eine erste Messleiterbahn (44) an der Leiterplatte (12),
- in Zuordnung zu der zweiten Stromschiene (18) eine zweite Messleiterbahn (46) an der Leiterplatte (12),
- einen Shunt-Widerstand (48) mit einem mit der ersten Stromschiene (16) und der ersten Messleiterbahn (44) verbundenen ersten Kontaktbereich (50) und einem mit der zweiten Stromschiene (18) und der zweiten Messleiterbahn (46) verbundenen zweiten Kontaktbereich (52),
**dadurch gekennzeichnet, dass** die Leiterplatte (12) in Zuordnung zu der ersten Stromschiene (16) eine erste Mess-Durchgriffsöffnung (24) aufweist, wobei die erste Stromschiene (16) einen in die erste Mess-Durchgriffsöffnung (24) eingesetzten Durchgriff/Kontakt-Bereich (26) aufweist, und wobei der erste Durchgriff/Kontakt-Bereich (26) der ersten Stromschiene (16) die im Bereich einer ersten Seite (32) der Leiterplatte (12) positionierte erste Shunt-Kontaktfläche (44) bereitstellt und die erste Stromschiene (16) sich an einer von der ersten Seite (32) abgewandten zweiten Seite (34) der Leiterplatte (12) erstreckt, und dass die Leiterplatte (12) in Zuordnung zu der zweiten Stromschiene (18) eine zweite Mess-Durchgriffsöffnung (36) aufweist, wobei die zweite Stromschiene (18) einen in die zweite Mess-Durchgriffsöffnung (36) eingesetzten zweiten Durchgriff/Kontakt-Bereich (38) aufweist, und wobei der zweite Durchgriff/Kontakt-Bereich (38) der zweiten Stromschiene (18) die im Bereich der ersten Seite (32) der Leiterplatte (12) positionierte zweite Shunt-Kontaktfläche (42) bereitstellt und die zweite Stromschiene (18) sich an der von der ersten Seite (32) abgewandten zweiten Seite (34) der Leiterplatte (12) erstreckt, und dass der erste Kontaktbereich (50) des Shunt-Widerstands (48) mit der ersten Stromschiene (16) und der ersten Messleiterbahn (44) durch Verlötung verbunden ist und der zweite Kontaktbereich (52) des Shunt-Widerstands (48) mit der zweiten Stromschiene (18) und der zweiten Messleiterbahn (46) durch Verlötung verbunden ist.

2. Strommessbaugruppe nach Anspruch 1, **dadurch gekennzeichnet, dass** die erste Shunt-Kontaktfläche (30) oder/und die zweite Shunt-Kontaktfläche (42) zu einer Oberfläche der Leiterplatte (12) an der ersten Seite (32) im Wesentlichen bündig liegt.

3. Strommessbaugruppe nach Anspruch 1 oder 2, **dadurch gekennzeichnet, dass** der erste Durchgriff/Kontakt-Bereich (26) eine napfartige Ausformung (28) an der ersten Stromschiene (16) umfasst, oder/und dass der zweite Durchgriff/Kontakt-Bereich (38) eine napfartige Ausformung (40) an der zweiten Stromschiene (18) umfasst.

4. Strommessbaugruppe nach einem der Ansprüche 1-3, **dadurch gekennzeichnet, dass** die erste Stromschiene (16) an der zweiten Seite (34) der Leiterplatte (12) in Abstand zur Leiterplatte (12) angeordnet ist, oder/und dass die zweite Stromschiene (18) an der zweiten Seite (34) der Leiterplatte (12) in Abstand zur Leiterplatte (12) angeordnet ist.

5. Strommessbaugruppe nach einem der Ansprüche 1-4, **dadurch gekennzeichnet, dass** der erste Durchgriff/Kontakt-Bereich (26) mit Presspassung in der ersten Mess-Durchgriffsöffnung (24) aufgenommen ist, oder/und dass der zweite Durchgriff/Kontakt-Bereich (38) mit Presspassung in der zweiten Mess-Durchgriffsöffnung (36) aufgenommen ist.

6. Strommessbaugruppe nach einem der Ansprüche 1-5, **dadurch gekennzeichnet, dass** bei wenigstens einem Kontaktbereich (50) von erstem Kontaktbereich (50) und zweitem Kontaktbereich (52) die Verlötung einen die zugeordnete Shunt-Kontaktfläche (30) im Wesentlichen vollständig überdeckenden und eine Verbindung mit der zugeordneten Messleiterbahn (44) herstellenden Verlötungsbereich (54) umfasst.

7. Strommessbaugruppe nach einem der Ansprüche 1-6, **dadurch gekennzeichnet, dass** bei wenigstens einem Kontaktbereich (52) von erstem Kontaktbereich (50) und zweitem Kontaktbereich (52) die Verlötung einen die zugeordnete Shunt-Kontaktfläche (42) im Wesentlichen vollständig überdeckenden ersten Verlötungsbereich (56) und einen von dem ersten Verlötungsbereich (56) getrennten, eine Verbindung mit der zugeordneten Messleiterbahn (46) herstellenden zweiten Verlötungsbereich (58) umfasst.

8. Strommessbaugruppe nach einem der vorangehenden Ansprüche, **gekennzeichnet durch** eine an der Leiterplatte (12) in Kontakt mit der ersten Messleiterbahn (44) und der zweiten Messleiterbahn (46) vorgesehene Messelektronik (14).

## Claims

1. Current-measuring unit, especially for measuring battery currents in a vehicle, comprising:
- a printed circuit board (12),
- a first bus bar (16), which leads to the printed circuit board (12) and is fixed at the printed circuit board (12), wherein the first bus bar (16) provides at least one first shunt contact surface (30),
- a second bus bar (18), which leads to the printed circuit board (12) and is fixed at the printed circuit board (12), wherein the second bus bar (18) provides at least one second shunt contact surface (42),
- a first measuring strip conductor (44) in association with the first bus bar (16) at the printed circuit board (12),
- a second measuring strip conductor (46) in association with the second bus bar (18) at the printed circuit board (12), and
- a shunt resistor (48) with a first contact area (50) connected to the first bus bar (16) and to the first measuring strip conductor (44) and with a second contact area (52) connected to the second bus bar (18) and to the second measuring strip conductor (46),
**characterized in that** the printed circuit board (12) has a first measuring passage opening (24) in association with the first bus bar (16), wherein the first bus bar (16) has a passage/contact area (26) inserted into the first measuring passage opening (24), and wherein the first passage/contact area (26) of the first bus bar (16) provides the first shunt contact surface (44) positioned in the area of a first side (32) of the printed circuit board (12) and the first bus bar (16) extends on a second side (34) of the printed circuit board (12), which second side faces away from the first side (32), and that the printed circuit board (12) has a second measuring passage opening (36) in association with the second bus bar (18), wherein the second bus bar (18) has a second passage/contact area (38) inserted into the second measuring passage opening (36), and wherein the second passage/contact area (38) of the second bus bar (18) provides the second shunt contact surface (42) positioned in the area of the first side (32) of the printed circuit board (12) and the second bus bar (18) extends on the second side (34) of the printed circuit board (12), which second side faces away from the first side (32), and that the first contact area (50) of the shunt resistor (48) is connected to the first bus bar (16) and the first measuring strip conductor (44) by soldering and the second contact area (52) of the shunt resistor (48) is connected to the second bus bar (18) and to the second measuring strip conductor (46) by soldering.

2. Current-measuring unit in accordance with claim 1, **characterized in that** the first shunt contact surface (30) or/and the second shunt contact surface (42) is located essentially flush with a surface of the printed circuit board (12) on the first side (32).

3. Current-measuring unit in accordance with claim 1 or 2, **characterized in that** the first passage/contact area (26) comprises a cup-like bulge (28) at the first bus bar (16), or/and that the second passage/contact area (38) comprises a cup-like bulge (40) at the second bus bar (18).

4. Current-measuring unit in accordance with one of the claims 1-3, **characterized in that** the first bus bar (16) is arranged on the second side (34) of the printed circuit board (12) at a spaced location from the printed circuit board (12), or/and that the second bus bar (18) is arranged on the second side (34) of the printed circuit board (12) at a spaced location from the printed circuit board (12).

5. Current-measuring unit in accordance with one of the claims 1-4, **characterized in that** the first passage/contact area (26) is accommodated in the first measuring passage opening (24) with press fit, or/and that the second passage/contact area (38) is accommodated in the second measuring passage opening (36) with press fit.

6. Current-measuring unit in accordance with one of the claims 1-5, **characterized in that** in at least one contact area (50) of the first contact area (50) and of the second contact area (52) the soldering comprises a soldering area (54) covering the associated shunt contact surface (30) essentially completely and a soldering area (54) establishing a connection to the associated measuring strip conductor (44).

7. Current-measuring unit in accordance with one of the claims 1-6, **characterized in that** in at least one contact area (5) of the first contact area (50) and of the second contact area (52), the soldering comprises a first soldering area (56) covering the associated first shunt contact surface (42) essentially completely and a second soldering area (58) establishing a connection to the associated measuring strip conductor (46).

8. Current-measuring unit in accordance with one of the above claims, **characterized by** a measuring electronic unit (14) provided at the printed circuit board (12) in contact with the first measuring strip conductor (44) and with the second measuring strip conductor (46).

## Revendications

1. Unité de mesure de courant, notamment pour la mesure du courant de batterie dans un véhicule, comprenant :
- une carte de circuit imprimé (12),
- un premier rail conducteur (16), qui mène à la carte de circuit imprimé (12) et est fixée à la carte de circuit imprimé (12), dans laquelle le premier rail conducteur (16) fournit au moins une première surface de contact de shunt (30),
- un deuxième rail conducteur (18), qui mène à la carte de circuit imprimé (12) et est fixée à la carte de circuit imprimé (12), dans laquelle le deuxième rail conducteur (18) fournit au moins une deuxième surface de contact de shunt (42),
- une première bande conductrice de mesure (44) en association avec le premier rail conducteur (16) sur la carte de circuit imprimé (12),
- une deuxième bande conductrice de mesure (46) en association avec le deuxième rail conducteur (18) sur la carte de circuit imprimé (12),
- une résistance de shunt (48) avec une première zone de contact (50) reliée au premier rail conducteur (16) et à la première bande conductrice de mesure (44) et avec une deuxième zone de contact (52) reliée au deuxième rail conducteur (18) et à la deuxième bande conductrice de mesure (46),
**caractérisé en ce que** la carte de circuit imprimé (12) a une première ouverture de passage de mesure (24) en association avec le premier rail conducteur (16), dans lequel le premier rail conducteur (16) a une zone de passage/contact (26) insérée dans la première ouverture de passage de mesure (24), et dans lequel la première zone de passage/contact (26) du premier rail conducteur (16) fournit la première surface de contact de shunt (44) positionnée dans la zone d'un premier côté (32) de la carte de circuit imprimé (12) et le premier rail conducteur (16) s'étend sur un deuxième côté (34) de la carte de circuit imprimé (12), lequel deuxième côté est orienté à l'opposé du premier côté (32), et la carte de circuit imprimé (12) a une deuxième ouverture de passage de mesure (36) en association avec le deuxième rail conducteur (18), dans lequel le deuxième rail conducteur (18) a une deuxième zone de passage/contact (38) insérée dans la deuxième ouverture de passage de mesure (36), et dans lequel la deuxième zone de passage/contact (38) du deuxième rail conducteur (18) fournit la deuxième surface de contact de shunt (42) positionnée dans la zone du premier côté (32) de la carte de circuit imprimé (12) et le deuxième rail conducteur (18) s'étend sur le deuxième côté (34) de la carte de circuit imprimé (12), la deuxième côté étant opposée au premier côté (32), et que la première surface de contact (50) de la résistance de shunt (48) est reliée par brasage au premier rail conducteur (16) et à la première bande conductrice de mesure (44) et que la deuxième surface de contact (52) de la résistance de shunt (48) est reliée par brasage au deuxième rail conducteur (18) et à la deuxième bande conductrice de mesure (46).

2. Unité de mesure de courant selon la revendication 1, **caractérisée en ce que** la première surface de contact de shunt (30) ou/et la deuxième surface de contact de shunt (42) est située essentiellement alignée d'une surface de la carte de circuit imprimé (12) sur le premier côté (32).

3. Unité de mesure de courant selon la revendication 1 ou 2, **caractérisée en ce que** la première zone de passage/contact (26) comprend un renflement en forme de coupe (28) au niveau du premier rail conducteur (16), ou/et **en ce que** la deuxième zone de passage/contact (38) comprend un renflement en forme de coupe (40) au niveau du deuxième rail conducteur (18).

4. Unité de mesure de courant selon l'une des revendications 1 à 3, **caractérisée en ce que** le premier rail conducteur (16) est disposé sur le deuxième côté (34) de la carte de circuit imprimé (12) à distance de la carte de circuit imprimé (12), ou/et **en ce que** le deuxième rail conducteur (18) est disposé sur le deuxième côté (34) de la carte de circuit imprimé (12) à distance de la carte de circuit imprimé (12).

5. Unité de mesure de courant selon l'une des revendications 1-4, **caractérisée en ce que** la première zone de passage/contact (26) est logée dans la première ouverture de passage de mesure (24) avec un ajustement serré, ou/et **en ce que** la deuxième zone de passage/contact (38) est logée dans la deuxième ouverture de passage de mesure (36) avec un ajustement serré.

6. Unité de mesure de courant selon l'une des revendications 1 à 5, **caractérisée en ce que** dans au moins une zone de contact (50) de la première zone de contact (50) et de la deuxième zone de contact (52), le brasage comprend une zone de brasage (54) recouvrant sensiblement complètement la surface de contact de shunt (30) associée et une zone de brasage (54) établissant une liaison avec la bande conductrice de mesure (44) associé.

7. Unité de mesure de courant selon l'une des revendications 1 à 6, **caractérisée en ce que**, dans au moins une zone de contact (5) de la première zone de contact (50) et de la deuxième zone de contact (52), le brasage comprend une première zone de brasage (56) recouvrant sensiblement complètement la première surface de contact de shunt (42) associée et une deuxième zone de brasage (58) établissant une liaison avec la bande conductrice de mesure (46) associé.

8. Unité de mesure de courant selon l'une des revendications précédentes, **caractérisée par** une unité électronique de mesure (14) prévue sur la carte de circuit imprimé (12) en contact avec la première bande conductrice de mesure (44) et avec la deuxième bande conductrice de mesure (46).
